(19) Europäisches Patentamt
European Patent Office
Office européen des brevets

(11) **EP 4 531 513 A1**

(12) **EUROPEAN PATENT APPLICATION**
published in accordance with Art. 153(4) EPC

(43) Date of publication:
**02.04.2025 Bulletin 2025/14**

(21) Application number: **22943664.7**

(22) Date of filing: **23.05.2022**

(51) International Patent Classification (IPC):
**H05K 9/00** (2006.01)

(52) Cooperative Patent Classification (CPC):
**H05K 9/00**

(86) International application number:
**PCT/JP2022/021147**

(87) International publication number:
**WO 2023/228258 (30.11.2023 Gazette 2023/48)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **TPR CO., LTD.**
**Tokyo 100-0005 (JP)**

(72) Inventors:
• **SUZUKI Katsuhito**
  **Tokyo 100-0005 (JP)**
• **SHIMIZU Toshiaki**
  **Tokyo 100-0005 (JP)**

(74) Representative: **Gill Jennings & Every LLP**
**The Broadgate Tower**
**20 Primrose Street**
**London EC2A 2ES (GB)**

(54) **ELECTROMAGNETIC WAVE ABSORBER AND ELECTROMAGNETIC WAVE SHIELDING COMPOSITE**

(57)     Provided are: an electromagnetic wave absorber including fibrous carbon; and an electromagnetic wave shielding composite including: the electromagnetic wave absorber; and an electromagnetic wave reflection layer formed on one surface side of the electromagnetic wave absorber. The electromagnetic wave absorber has a complex permittivity with a real part of from 6 to 30 and an imaginary part of from 1 to 25 at a frequency of 24 GHz. When the electromagnetic wave absorber is cut, the number of fiber bundles of the fibrous carbon observed on a cut surface of the electromagnetic wave absorber, the fiber bundles each having a maximum diameter of 100 nm or more, is 10 or less per 10 $\mu$m $\times$ 10 $\mu$m.

**FIG. 1**

## Description

Technical Field

The present invention relates to an electromagnetic wave absorber containing fibrous carbon and an electromagnetic wave shielding composite using the electromagnetic wave absorber.

Background Art

In recent years, the frequency band of an electromagnetic wave used in a communication device, a radar, and the like has been increased at an accelerating rate. Under such electromagnetic environment, electromagnetic wave absorbers are used to suppress malfunctions and like caused by electromagnetic wave interference between devices or between circuits within the devices.

In recent years, expectations have been rising for a shift from the related-art 4th generation mobile communication system (4G) to the 5th generation mobile communication system (5G) in order to achieve higher capacity and higher speed communication. It is said that the 5G mainly uses frequency bands of 18 GHz or more in many cases. Thus, there is an increasing need for electromagnetic wave absorbers for maintaining the electromagnetic wave environment in order to prevent malfunctions in high-frequency band regions.

A soft magnetic metal material has hitherto been used for an electromagnetic wave absorber. However, in an electromagnetic wave absorber using a soft magnetic metal material, its relative permeability is known to be rapidly decreased in a GHz band in accordance with Snoek's limit law, and its electromagnetic wave absorbing ability is also decreased in association with the foregoing. In addition, the soft magnetic metal material is a material having a high specific gravity, and hence the weight of the electromagnetic wave absorber using the soft magnetic metal material is increased to cause a factor for inhibiting the reduction in weight of the electromagnetic wave absorber. In addition, when an electromagnetic wave absorber on a high-frequency band side is produced through use of the soft magnetic metal material, it is required to blend a large amount of an absorbing material owing to its low absorbability, with the result that its molding processability is poor in addition to an increase in weight.

In addition, the use of a carbon material as a material for the electromagnetic wave absorber has also been investigated (see Patent Literature 1).

Citation List

Patent Literature

[PTL 1] WO 2021/230140 A1

Summary of Invention

Technical Problem

A carbon material has also been investigated as a material for the electromagnetic wave absorber, but sufficient absorption characteristics for an electromagnetic wave in a high-frequency band of more than 18 GHz have not been achieved.

Thus, an object of the present invention is to provide an electromagnetic wave absorber and an electromagnetic wave shielding composite having high electromagnetic wave absorption characteristics in a high-frequency band of more than 18 GHz when being arranged to be used on the surface of an electromagnetic wave reflection layer such as a metal layer.

Solution to Problem

The present invention provides the following.

<1> An electromagnetic wave absorber, including fibrous carbon,

wherein the electromagnetic wave absorber has a complex permittivity with a real part of from 6 to 30 and an imaginary part of from 1 to 25 at a frequency of 24 GHz, and
wherein, when the electromagnetic wave absorber is cut, the number of fiber bundles of the fibrous carbon observed on a cut surface of the electromagnetic wave absorber, the fiber bundles each having a maximum diameter of 100 nm or more, is 10 or less per 10 μm×10 μm.

<2> The electromagnetic wave absorber according to Item <1>, wherein, when the electromagnetic wave absorber is cut, a ratio of the number of the fiber bundles each having a maximum diameter of 5 nm or more and less than 100 nm to a total of the number of the fiber bundles each having a maximum diameter of 5 nm or more and less than 100 nm, and the number of the fiber bundles each having a maximum diameter of 100 nm or more observed per 10 μm×10 μm of the cut surface of the electromagnetic wave absorber is 80% or more.
<3> The electromagnetic wave absorber according to Item <1> or <2>, wherein the electromagnetic wave absorber includes the fibrous carbon in a content of from 0.2 mass% to 1.5 mass%.
<4> The electromagnetic wave absorber according to any one of Items <1> to <3>,

wherein the electromagnetic wave absorber includes the fibrous carbon and a base material, and
wherein the base material contains at least one kind selected from a resin, an elastomer, and a rubber.

<5> The electromagnetic wave absorber according to Item <4>, wherein the base material contains at least one kind selected from a silicone resin, a silicone elastomer, and a silicone rubber.
<6> The electromagnetic wave absorber according to any one of Items <1> to <5>, wherein the fibrous carbon is a carbon nanotube.
<7> The electromagnetic wave absorber according to Item <1> or <2>,

wherein the electromagnetic wave absorber includes the fibrous carbon and a base material,
wherein the fibrous carbon is a carbon nanotube,
wherein the base material contains at least one kind selected from a silicone resin, a silicone elastomer, and a silicone rubber, and
wherein the electromagnetic wave absorber includes the fibrous carbon in a content of from 0.2 mass% to 1.5 mass%.

<8> The electromagnetic wave absorber according to any one of Items <1> to <7>, wherein the electromagnetic wave absorber has an elongation at break measured in conformity with JIS K 6251:2017 of 150% or more.
<9> The electromagnetic wave absorber according to any one of Items <1> to <8>, wherein the electromagnetic wave absorber has a thickness of from 0.2 mm to 2.0 mm.
<10> The electromagnetic wave absorber according to any one of Items <1> to <9>, wherein the electromagnetic wave absorber has a specific gravity of 2.5 or less.
<11> The electromagnetic wave absorber according to any one of Items <1> to <10>, wherein the electromagnetic wave absorber has a total light transmittance measured in conformity with ISO 13468 of 20% or less.
<12> An electromagnetic wave shielding composite, including:

the electromagnetic wave absorber of any one of Items <1> to <11>; and
an electromagnetic wave reflection layer formed on one surface side of the electromagnetic wave absorber.

Advantageous Effects of Invention

According to the present invention, there can be provided the electromagnetic wave absorber and the electromagnetic wave shielding composite having high electromagnetic wave absorption characteristics in a high-frequency band of more than 18 GHz when being arranged to be used on the surface of the electromagnetic wave reflection layer such as a metal layer. The present invention contributes to Goal 3 "Good health and well-being for all" and Goal 12 "Responsible production and consumption" of the 17 goals of Sustainable Development Goals (SDGs).

Brief Description of Drawings

FIG. 1 is a graph showing a relationship between a real part and an imaginary part of a complex permittivity satisfying a non-reflective conditional equation.
FIG. 2 is a graph showing a return loss of each of electromagnetic wave absorbers of Examples 1, 2, and 4.
FIG. 3 is a graph showing a return loss of each of electromagnetic wave absorbers of Examples 3 and 5.

Description of Embodiments

A numerical range represented through use of the expression "to" as used herein means a range including numerals in front of and behind the "to" as a lower limit value and an upper limit value, respectively.

<Electromagnetic Wave Absorber>

An electromagnetic wave absorber of the present invention is an electromagnetic wave absorber including fibrous carbon, the electromagnetic absorber being characterized in

that the electromagnetic wave absorber has a complex permittivity with a real part of from 6 to 30 and an imaginary part of from 1 to 25 at a frequency of 24 GHz, and
that, when the electromagnetic wave absorber is cut, the number of fiber bundles of the fibrous carbon observed on a cut surface of the electromagnetic wave absorber, the fiber bundles each having a maximum diameter of 100 nm or more, is 10 or less per 10 $\mu$m$\times$10 $\mu$m.

When the electromagnetic wave absorber of the present invention is arranged to be used on the surface of a material such as a metal that reflects an electromagnetic wave, the electromagnetic wave absorber can reduce reflected waves by controlling the amplitude and phase of each of a reflected wave from a metal surface and a reflected wave from an electromagnetic wave absorber front surface (surface on a side opposite to the side on which the metal is arranged). Thus, when the electromagnetic wave absorber of the present invention is arranged to be used on the surface of a material such as a metal that reflects an electromagnetic wave, the electromagnetic wave absorber can efficiently absorb the electromagnetic wave. The electromagnetic wave absorber that reduces an electromagnetic wave through such mechanism is also called a resonant type electromagnetic wave absorber. In the resonant type electromagnetic wave absorber, when the following equation called a non-reflective conditional equation is satisfied, an electromagnetic wave to be reflected is theoretically eliminated.

$$ 1 - \frac{1}{\sqrt{\varepsilon}} \tanh\left( j \frac{2\pi d}{\lambda} \sqrt{\varepsilon} \right) \cdots (1) $$

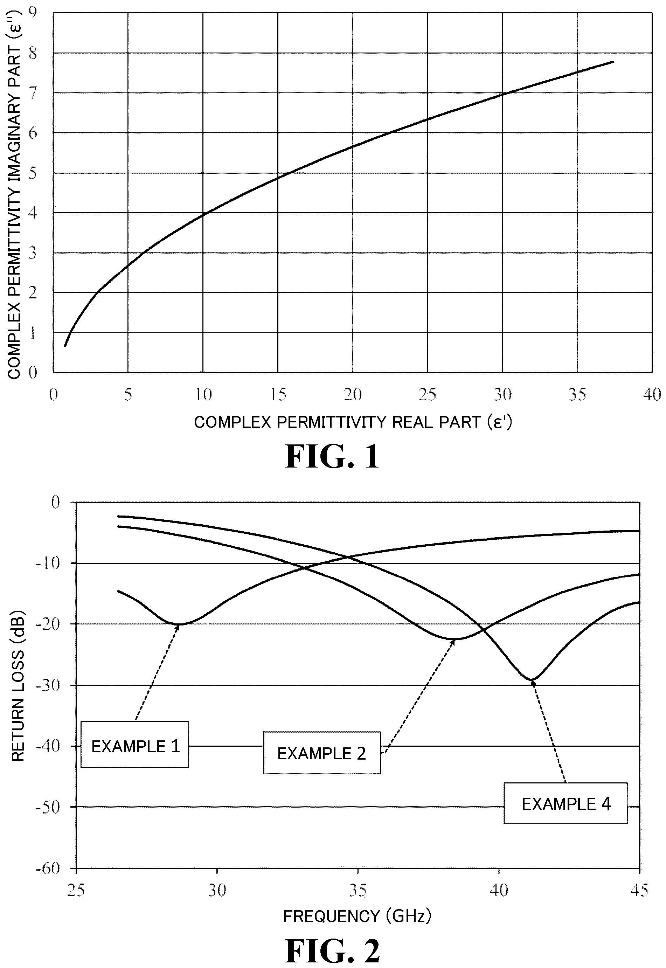

In the equation (1), "tanh" represents an operator having a hyperbolic tangent function, "$\varepsilon$" represents a complex permittivity, "j" represents an imaginary unit, "d" represents the thickness of an electromagnetic wave absorber (dielectric layer), and "$\lambda$" represents the wavelength of an electromagnetic wave.
When a graph is drawn with the real part of the complex permittivity in the equation (1) being the x-axis and the imaginary part thereof being the y-axis, such a graph as shown in FIG. 1 is obtained. When an electromagnetic wave is attenuated, the value of the imaginary part is generally large.
According to the investigations made by the inventors of the present invention, it has been found that, when the real part and imaginary part of the complex permittivity are designed so as to approach the above-mentioned non-reflective conditions while the properties, dispersion state, and the like of the fibrous carbon in the electromagnetic wave absorber are controlled, the complex permittivity is plotted in the vicinity of the non-reflective curve shown in FIG. 1 and high electromagnetic wave absorption characteristics can be obtained with the addition of a smaller amount of fibrous carbon as compared to that in the related-art method.
That is, in the electromagnetic wave absorber of the present invention, the complex permittivity of the electromagnetic wave absorber is plotted in the vicinity of the non-reflective curve shown in FIG. 1 and high electromagnetic wave absorption characteristics can be obtained with the addition of a smaller amount of fibrous carbon as compared to that in the related-art method by: adjusting the real part of the complex permittivity to from 6 to 30 and the imaginary part thereof to from 1 to 25; and further adjusting the dispersion state of the fibrous carbon in the electromagnetic wave absorber so that the number of fiber bundles (fiber bundles of the fibrous carbon) observed on the cut surface of the electromagnetic wave absorber, the fiber bundles each having a maximum diameter of 100 nm or more, may be 10 or less per 10 $\mu$m$\times$10 $\mu$m.
In the graph of FIG. 1, when the value of d/$\lambda$ is small, that is, when the thickness of the electromagnetic wave absorber becomes smaller as compared to the wavelength, the real part and imaginary part of the complex permittivity shift to smaller values on the graph. When the value of d/$\lambda$ is large, that is, when the thickness of the electromagnetic wave absorber becomes larger as compared to the wavelength, the real part and imaginary part of the complex permittivity shift to larger values. The fibrous carbon forms a network by being dispersed in the electromagnetic wave absorber, and hence can be drawn as an equivalent circuit including reactance and capacitance. Thus, when the frequency band is higher, the loss of an electromagnetic wave is increased. Further, when the degree of dispersion is higher, fine capacitors tend to be present, and hence the loss of an electromagnetic wave is increased. That is, when the real part of the complex permittivity is the same in FIG. 1, the imaginary part of the complex permittivity tends to be increased when the dispersibility of the fibrous carbon is high. The complex permittivity of the electromagnetic wave absorber is increased when the concentration of the fibrous carbon in the electromagnetic wave absorber is increased. However, when the degree of dispersion of the fibrous carbon is high, the concentration that intersects with the non-reflective curve is present even when the concentration is increased from an extremely small amount. Thus, high electromagnetic wave absorption characteristics can be expressed.

That is, in the electromagnetic wave absorber of the present invention, even when the content of the fibrous carbon in the electromagnetic wave absorber is as small as from 0.2 mass% to 1.5 mass%, the high electromagnetic wave absorption characteristics can be expressed by adjusting the dispersion state of the fibrous carbon in the electromagnetic wave absorber so that the number of fiber bundles observed on the cut surface of the electromagnetic wave absorber, the fiber bundles each having a maximum diameter of 100 nm or more, may be 10 or less per 10 $\mu$m$\times$10 $\mu$m.

In the electromagnetic wave absorber of the present invention, the real part of the complex permittivity at a frequency of 24 GHz is from 6 to 30, preferably from 6 to 25, more preferably from 7 to 20. When the real part of the complex permittivity falls within the above-mentioned ranges, higher electromagnetic wave absorption characteristics are obtained in a high-frequency band of more than 5 GHz (particularly preferably a high-frequency band of more than 18 GHz).

In the electromagnetic wave absorber of the present invention, the imaginary part of the complex permittivity at a frequency of 24 GHz is from 1 to 25, preferably from 1.5 to 20, more preferably from 2 to 15. When the imaginary part of the complex permittivity falls within the above-mentioned ranges, higher electromagnetic wave absorption characteristics are obtained in a high-frequency band of more than 5 GHz (particularly preferably a high-frequency band of more than 18 GHz) .

As means for adjusting the real part and imaginary part of the complex permittivity of the electromagnetic wave absorber at a frequency of 24 GHz to the above-mentioned ranges, there is given a method involving adjusting the content, kind, dispersibility, and the like of the fibrous carbon. In order to enhance the dispersibility of the fibrous carbon in the electromagnetic wave absorber, there are given a method involving mixing fibrous carbon dispersed in a liquid phase with a base material, such as a resin, a rubber, or an elastomer, dispersed in a liquid phase and compounding the mixture by drying, and a method involving mixing and dispersing fibrous carbon into a base material by applying a strong shearing force with a mixer, a roll, or the like. Through use of fibrous carbon having a long fiber length and a thin fiber bundle, the real part and imaginary part of the complex permittivity are more easily adjusted to the above-mentioned ranges even when the amount of the fibrous carbon is small. Through use of such fibrous carbon, the network effect of the fibrous carbon is increased to enable an electromagnetic wave to be efficiently absorbed. In addition, when the fiber length of the fibrous carbon is increased, the conductivity of the electromagnetic wave absorber is increased, and hence the loss caused by fiber resistance can also be increased.

More specifically, for example, when carbon nanotubes are used as the fibrous carbon, the conductivity of the electromagnetic wave absorber can be increased by increasing the average length of the carbon nanotubes, and hence the total amount of loss of an electromagnetic wave caused by the fiber network can be increased. In addition, the imaginary part of the complex permittivity can be increased by decreasing the average diameter of the carbon nanotubes. From the above-mentioned tendency, both the real part and imaginary part of the complex permittivity of the electromagnetic wave absorber can be increased by: increasing the aspect ratio of the carbon nanotubes, that is, increasing the fiber length of each of the carbon nanotubes; and reducing the average diameter thereof. Thus, even when the blending amount of the carbon nanotubes is small, the values of the real part and imaginary part of the complex permittivity of the electromagnetic wave absorber can be brought close to the non-reflective curve shown in FIG. 1.

In the electromagnetic wave absorber of the present invention, the number of fiber bundles observed on the cut surface of the electromagnetic wave absorber, the fiber bundles each having a maximum diameter of 100 nm or more, is 10 or less, preferably 9 or less, more preferably 8 or less, still more preferably 6 or less per 10 $\mu$m$\times$10 $\mu$m. When the number of the fiber bundles each having a maximum diameter of 100 nm or more is 10 or less, the dispersibility of the fibrous carbon in the electromagnetic wave absorber is satisfactory, and an electromagnetic wave can be efficiently absorbed by: the conductive loss caused by an increase in probability that an electromagnetic wave having entered the electromagnetic wave absorber collides with the fibrous carbon; and the dielectric loss caused by the capacitance between the molecules of the fibrous carbon. Thus, higher electromagnetic wave absorption characteristics are obtained.

As means for setting the above-mentioned number of fiber bundles each having a maximum diameter of 100 nm or more observed on the cut surface to 10 or less per 10 $\mu$m$\times$10 $\mu$m, there are given a method involving adjusting the kind and content of the fibrous carbon, a method involving producing an electromagnetic wave absorber by using the fibrous carbon in the form of a masterbatch supported on a carrier polymer material, and a method involving dispersing the fibrous carbon by applying a strong shearing force with a device, such as a kneader or a twin-screw extruder.

In the electromagnetic wave absorber of the present invention, when the electromagnetic wave absorber is cut, the ratio of the number of the fiber bundles each having a maximum diameter of 5 nm or more and less than 100 nm to a total of the number of the fiber bundles each having a maximum diameter of 5 nm or more and less than 100 nm, and the number of the fiber bundles each having a maximum diameter of 100 nm or more observed per 10 $\mu$m$\times$10 $\mu$m of the cut surface of the electromagnetic wave absorber is preferably 50% or more, more preferably 80% or more, still more preferably 90% or more. According to this aspect, the dispersibility of the fibrous carbon in the electromagnetic wave absorber is satisfactory, and a dense three-dimensional network of the fibrous carbon is formed in the electromagnetic wave absorber. Thus, an electromagnetic wave can be efficiently absorbed by: the conductive loss caused by an increase in probability that an electromagnetic wave having entered the electromagnetic wave absorber collides with the fibrous carbon; and the dielectric loss caused by the capacitance between the molecules of the fibrous carbon. Thus, higher electromagnetic wave absorption characteristics are obtained.

As used herein, the fiber bundle observed on the cut surface of the electromagnetic wave absorber refers to fibrous carbon partially or entirely bundled on the cut surface of the electromagnetic wave absorber. On the cut surface of the electromagnetic wave absorber, a plurality of fiber bundles may overlap each other. However, when individual fiber bundles are independent, the independent fiber bundles are each counted as one fiber bundle. That is, when two overlapping fiber bundles each having a maximum diameter of 100 nm or more are observed on the cut surface of the electromagnetic wave absorber, the number of the fiber bundles each having a maximum diameter of 100 nm or more is set to two.

The total light transmittance measured in conformity with ISO 13468 of the electromagnetic wave absorber of the present invention is preferably 20% or less, more preferably 15% or less, still more preferably 10% or less. According to this aspect, the dispersibility of the fibrous carbon in the electromagnetic wave absorber is satisfactory, and an electromagnetic wave can be efficiently absorbed, with the result that higher electromagnetic wave absorption characteristics are obtained.

The specific gravity of the electromagnetic wave absorber of the present invention is preferably 2.5 or less, more preferably 2.2 or less, still more preferably 2 or less.

The elongation at break measured in conformity with JIS K 6251:2017 of the electromagnetic wave absorber of the present invention is preferably 150% or more, more preferably 200% or more, still more preferably 250% or more. According to this aspect, the electromagnetic wave absorber of the present invention has flexibility and hence may be applied to, for example, members having various shapes.

The electromagnetic wave absorbing ability at a frequency of from 18 GHz to 110 GHz of the electromagnetic wave absorber of the present invention is measured by measuring the amount of attenuation of an electromagnetic wave that has entered the electromagnetic wave absorber in a state of being bonded to a reflection layer made of aluminum or the like. The minimum peak of the return loss of the electromagnetic wave absorber measured in this manner is preferably -15 dB or less, more preferably -20 dB or less.

The shape of the electromagnetic wave absorber of the present invention is not particularly limited, and may be appropriately selected in accordance with purposes and applications. Examples of the shape include a sheet shape, a plate shape, and a rod shape.

The thickness of the electromagnetic wave absorber of the present invention is preferably from 0.1 mm to 2.0 mm. The upper limit is preferably 1.8 mm or less, more preferably 1.5 mm or less. The lower limit is preferably 0.15 mm or more, more preferably 0.2 mm or more.

(Fibrous Carbon)

The electromagnetic wave absorber of the present invention includes the fibrous carbon. The content of the fibrous carbon in the electromagnetic wave absorber is preferably from 0.2 mass% to 1.5 mass%. The upper limit is preferably 1.4 mass% or less, more preferably 1.2 mass% or less. When the content of the fibrous carbon is too large, there is a tendency in that an electromagnetic wave that has entered the electromagnetic wave absorber is easily reflected from the vicinity of the surface of the electromagnetic wave absorber, and hence the electromagnetic wave is not easily incorporated into the electromagnetic wave absorber. When the content of the fibrous carbon falls within the above-mentioned ranges, a three-dimensional network structure of the fibrous carbon is easily formed in the electromagnetic wave absorber. When such three-dimensional network structure is formed in the electromagnetic wave absorber, an electromagnetic wave can be efficiently absorbed by: the conductive loss caused by an increase in probability that an electromagnetic wave having entered the electromagnetic wave absorber collides with the fibrous carbon; and the dielectric loss caused by the capacitance between the molecules of the fibrous carbon. Thus, an electromagnetic wave absorber excellent in absorption characteristics of an electromagnetic wave in a high-frequency band can be obtained.

Examples of the fibrous carbon include a carbon nanotube, a carbon nanofiber, a carbon nanohorn, and a carbon fiber. Of those, a carbon nanotube is preferred.

A carbon nanotube is a substance in which a graphene sheet is formed into a single-layer or multilayer tubular shape. The carbon nanotube as used herein also encompasses a cone-shaped material called a carbon nanohorn.

The carbon nanotube may be a single-layer carbon nanotube or a multilayer carbon nanotube. The carbon nanotube is preferably a carbon nanotube formed of from a single layer to 20 layers, more preferably a carbon nanotube formed of from a single layer to 15 layers, still more preferably a carbon nanotube formed of from a single layer to 10 layers from the viewpoints of various kinds of performance, such as mechanical characteristics, conductivity, and heat conductivity, material cost, and the like. Both ends of the carbon nanotube may be opened, or any one or both of the ends may be closed.

The average diameter of the carbon nanotubes is preferably from 0.03 nm to 200 nm. The lower limit of the average diameter is preferably 1 nm or more, more preferably 3 nm or more, still more preferably 5 nm or more. The upper limit of the average diameter is preferably 150 nm or less, more preferably 100 nm or less, still more preferably 50 nm or less.

The average length of the carbon nanotubes is preferably from 0.0005 mm to 3 mm. The lower limit of the average length is preferably 0.0006 mm or more, more preferably 0.0008 mm or more, still more preferably 0.001 mm or more. The upper limit thereof is preferably 3 mm or less, more preferably 2.5 mm or less, still more preferably 2 mm or less.

The average aspect ratio of the carbon nanotubes is preferably from 50 to 500,000. When the average aspect ratio of the carbon nanotubes falls within the above-mentioned range, higher electromagnetic wave absorption characteristics are obtained in a high-frequency band of more than 5 GHz (particularly preferably a high-frequency band of more than 18 GHz) even with a small blending amount. The lower limit of the average aspect ratio of the carbon nanotubes is preferably 100 or more, more preferably 150 or more, still more preferably 200 or more, yet still more preferably 1,000 or more, particularly preferably 10,000 or more. The upper limit of the average aspect ratio of the carbon nanotubes is preferably 450,000 or less, more preferably 400,000 or less, still more preferably 300,000 or less. As used herein, the average aspect ratio of the carbon nanotubes refers to a ratio (average length/average diameter) of the average length of the carbon nanotubes to the average diameter thereof.

As used herein, the average diameter of the carbon nanotubes is a value obtained by measuring the diameters (outer diameters) of 30 randomly selected carbon nanotubes with a scanning electron microscope or a transmission electron microscope and calculating an average value thereof. In addition, the average length of the carbon nanotubes is a value obtained by measuring the lengths of 30 randomly selected carbon nanotubes with a scanning electron microscope or a transmission electron microscope and calculating an average value thereof.

The specific surface area of the carbon nanotubes is preferably from 100 $m^2/g$ to 800 $m^2/g$. The lower limit of the specific surface area is preferably 150 $m^2/g$ or more, more preferably 200 $m^2/g$ or more. The upper limit of the specific surface area is preferably 550 $m^2/g$ or less, more preferably 500 $m^2/g$ or more. As used herein, the specific surface area of the carbon nanotubes is a value in terms of a BET specific surface area measured by a gas adsorption method (multipoint method) in conformity with JIS Z8830 (ISO 9277).

The carbon nanotube can be produced by a known method, such as an arc method, a laser ablation method, or a chemical vapor deposition method (CVD method). In addition, the carbon nanotube can also be produced by the method described in paragraphs 0029 to 0038 of JP 2020-180251 A.

The carbon nanotube may be subjected to oxidation treatment or may be modified with a polymer so that an acidic group or a basic group may be introduced onto the surface thereof. The acidic group is, for example, a carboxy group, and the basic group is, for example, an amine group.

In the electromagnetic wave absorber of the present invention, the carbon nanotubes are preferably contained in the form of a masterbatch supported on a carrier polymer material. The carbon nanotubes are bulky materials that are easily aggregated. However, when the carbon nanotubes are used in the form of a masterbatch supported on a carrier polymer material, the aggregation of the carbon nanotubes during the production of an electromagnetic wave absorber can be suppressed, and hence an electromagnetic wave absorber excellent in dispersibility of the carbon nanotubes can be obtained. In addition, an electromagnetic wave absorber excellent in dispersibility of the carbon nanotubes can be obtained even without performance of excessive dispersion treatment during the production of the electromagnetic wave absorber. Thus, the cutting of the carbon nanotubes caused by mechanical shearing can be suppressed, and hence the high aspect ratio of the carbon nanotubes can be maintained. In addition, the dispersibility of the carbon nanotubes in the electromagnetic wave absorber can be enhanced, and hence the dielectric loss in a high-frequency band is further increased, with the result that the electromagnetic wave absorption characteristics in the high-frequency band can be further improved.

The carrier polymer material that supports the carbon nanotube is not particularly limited, and examples thereof include a resin, a elastomer, and a rubber. The resin may be a thermoplastic resin, or may be a thermosetting resin. An example of the resin is a known material, and examples thereof include a polyester resin, a polyether resin, a polyolefin resin (e.g., a polyethylene resin or a polypropylene resin), a polystyrene resin, a polyamide resin, a polycarbonate resin, an acrylic resin, a polyvinyl chloride resin, a polyphenylene sulfide resin, a polyphenylene ether resin, a polytetrafluoroethylene resin, a polyimide resin, a polyamide imide resin, a polyether imide resin, a polysulfone resin, a polyether sulfone resin, a polyketone resin, a polyether ketone resin, a polyether ether ketone resin, a polyarylate resin, a polyether nitrile resin, a phenol resin, a phenoxy resin, a fluororesin, a urea resin, a melamine resin, a benzoguanamine resin, an alkyd resin, an epoxy resin, a silicone resin, a urethane resin, a furan resin, and a xylene resin. An example of the elastomer is a known material, and examples thereof include a polystyrene elastomer, a polyolefin elastomer, a polyurethane elastomer, a polyester elastomer, a polyamide elastomer, a polybutadiene elastomer, a polyisoprene elastomer, a fluorine-based elastomer, and a silicone elastomer. An example of the rubber is a known material, and examples thereof include a natural rubber (NR), a styrene-butadiene rubber (SBR), an acrylonitrile-butadiene rubber (NBR), a nitrile rubber, a hydrogenated nitrile rubber, a polyisoprene rubber (IR), a butadiene rubber (BR), a butyl rubber (IIR), a chloroprene rubber (CR), an acrylic rubber (ACM), a fluorine rubber (FKM or PTFE), and a silicone rubber. The weight-average molecular weight of the carrier polymer material is preferably from 5,000 to 15,000,000, more preferably from 8,000 to 13,000,000, still more preferably from 10,000 to 10,000,000. As used herein, the weight-average molecular weight of the carrier polymer material means the weight-average molecular weight in terms of polystyrene measured by gel permeation chromatography (GPC).

The carrier polymer material is preferably at least one kind selected from a silicone resin, a silicone elastomer, and a silicone rubber, more preferably a silicone rubber for the reasons of heat resistance, chemical resistance, and durability.

The content of the carbon nanotubes in the masterbatch is preferably from 0.05 mass% to 30 mass%, more preferably from 0.1 mass% to 25 mass%, still more preferably from 0.5 mass% to 20 mass%.

The masterbatch can be produced through:

a step of mixing a carbon nanotube dispersion liquid containing carbon nanotubes and a solvent with a carrier polymer material-containing solution containing a carrier polymer material and a solvent to prepare a mixed liquid (mixed liquid preparation step); and
a step of solidifying the above-mentioned mixed liquid to produce a solidified product containing the carbon nanotubes and the carrier polymer material (solidifying step). Each step is described below.

In the mixed liquid preparation step, the carbon nanotube dispersion liquid and the carrier polymer material-containing solution are mixed to prepare the mixed liquid.

First, the carbon nanotube dispersion liquid is described. Examples of the carbon nanotubes contained in the carbon nanotube dispersion liquid include those described above.

Examples of the solvent in the carbon nanotube dispersion liquid include water, methanol, ethanol, normal propanol, isopropanol, tert-butyl alcohol, tetrahydrofuran, acetone, and acetonitrile. Of those, water is preferred. Water has a high specific permittivity, and hence the dispersibility of the carbon nanotubes in the dispersion liquid also becomes satisfactory when water is used as a solvent.

The carbon nanotube dispersion liquid preferably contains an anionic dispersant. Examples of the anionic group include a carboxy group, a sulfo group, a phospho group, and salts thereof. A hydrogen atom may be dissociated from each of the carboxy group, the sulfo group, and the phospho group. Examples of atoms or atom groups for forming the salts include an alkali metal ion, an alkaline earth metal ion, an ammonium ion, an onium ion of an organic amine, and metal ions, such as a copper ion, a silver ion, an aluminum ion, and a tin ion. Specific examples of the anionic dispersant include: carboxymethyl cellulose, carrageenan, pectin, gum arabic, xanthan gum, gellan gum, agar, gum tragacanth, and salts thereof; an anion-modified polyvinyl alcohol; and an anion-modified polyacrylamide. Of those, carboxymethyl cellulose and a salt thereof are each preferred as the anionic dispersant. The weight-average molecular weight of the anionic dispersant is preferably from 1,000 to 20,000,000. The upper limit of the weight-average molecular weight is preferably 15,000,000 or less, more preferably 10,000,000 or less. The lower limit of the weight-average molecular weight is preferably 10,000 or more, more preferably 50,000 or more, still more preferably 100,000 or more.

The pH of the carbon nanotube dispersion liquid is preferably from 6 to 11, more preferably from 7 to 11. When the pH of the carbon nanotube dispersion liquid falls within the above-mentioned ranges, the dispersibility of the carbon nanotubes is satisfactory. As used herein, the value of pH refers to a value at 25°C.

The solid content concentration of the carbon nanotube dispersion liquid is preferably from 0.01 mass% to 15 mass%, more preferably from 0.05 mass% to 10 mass%, still more preferably from 0.08 mass% to 8 mass%. When the solid content concentration of the carbon nanotube dispersion liquid falls within the above-mentioned ranges, a solidified product can be more efficiently obtained. Further, the dispersibility of the carbon nanotubes in the carbon nanotube dispersion liquid is also satisfactory. In addition, the content of the carbon nanotubes in the carbon nanotube dispersion liquid is preferably from 0.01 mass% to 10 mass%, more preferably from 0.05 mass% to 8 mass%, still more preferably from 0.1 mass% to 5 mass%.

Next, the carrier polymer material-containing solution is described. Examples of the carrier polymer material contained in the carrier polymer material-containing solution include the carrier polymer materials described above.

Examples of the carrier polymer material-containing solution include a latex, an emulsion, and a resin particle dispersion liquid.

The latex or emulsion used as the carrier polymer material-containing solution can be prepared, for example, by synthesizing a carrier polymer material, such as a resin, an elastomer, or a rubber, by an emulsion polymerization method in the presence of an emulsifier to provide a reaction liquid, and using the reaction liquid as it is, or appropriately diluting the reaction liquid or adding an emulsifier thereto. Alternatively, the latex or emulsion may be prepared by transferring a reaction liquid obtained by synthesizing a carrier polymer material, such as a resin, an elastomer, or a rubber, into an aqueous system in the presence of an emulsifier by a solution polymerization method.

The resin particle dispersion liquid used as the carrier polymer material-containing solution can be prepared by dispersing resin particles in a solvent in the presence of a surfactant or a dispersant.

Examples of the solvent to be incorporated in the carrier polymer material-containing solution include water, methanol, ethanol, normal propanol, isopropanol, tert-butyl alcohol, tetrahydrofuran, acetone, and acetonitrile. Of those, water is preferred.

The pH of the carrier polymer material-containing solution is preferably from 6 to 11, more preferably from 7 to 11.

The solid content concentration of the carrier polymer material-containing solution is preferably from 0.5 mass% to 70 mass%, more preferably from 1 mass% to 65 mass%, still more preferably from 2 mass% to 60 mass%. When the solid content concentration of the carrier polymer material-containing solution falls within the above-mentioned ranges, a solidified product can be more efficiently obtained. In addition, the content of the carrier polymer material in the carrier polymer material-containing solution is preferably from 0.5 mass% to 60 mass%, more preferably from 1 mass% to 50 mass%.

The pH of the mixed liquid obtained in the mixed liquid preparation step is preferably from 6 to 11, more preferably from 7 to 11.

The solid content concentration of the mixed liquid obtained in the mixed liquid preparation step is preferably from 0.5 mass% to 15 mass%, more preferably from 1 mass% to 10 mass%, still more preferably from 2 mass% to 8 mass%. Further, regarding the ratio between the carbon nanotubes and the carrier polymer material in the mixed liquid, the ratio of the carrier polymer material is preferably from 200 parts by mass to 9,900 parts by mass, more preferably from 250 parts by mass to 9,800 parts by mass, still more preferably from 300 parts by mass to 9,700 parts by mass with respect to 100 parts by mass of the carbon nanotubes.

The solidifying step can be performed by adding an acid or a salt to the mixed liquid obtained in the mixed liquid preparation step.

Examples of the acid include formic acid, sulfuric acid, hydrochloric acid, and acetic acid. Examples of the salt include monovalent to trivalent metal salts including sodium chloride, magnesium chloride, and calcium salts, such as calcium nitrate and calcium chloride. Of those, calcium chloride is preferred.

In the solidifying step, it is preferred that a cationic polymer be added as a solidification accelerator to the above-mentioned mixed liquid after the acid or the salt is added to the above-mentioned mixed liquid, or the acid or the salt be added to the above-mentioned mixed liquid after the cationic polymer is added to the above-mentioned mixed liquid. In particular, it is more preferred that the acid or the salt be added to the above-mentioned mixed liquid after the cationic polymer is added to the above-mentioned mixed liquid. A solidified product can be more efficiently obtained by adding the acid or the salt after connecting the carbon nanotubes and the carrier polymer material with the cationic polymer.

An example of the cationic polymer is a polymer having a cationic group. Examples of the cationic group include an amino group, an ammonium group, an imino group, and salts thereof. Examples of atoms or atom groups for forming the salts include a hydroxide ion, a halogen ion, a carboxylic acid ion, a sulfonic acid ion, a fluorine ion, a cyanide ion, a silicic acid ion, a boric acid ion, and a condensed phosphoric acid ion. The amino group given as an example of the cationic group is not limited to $-NH_2$, and examples thereof also include a substituted amino group and a cyclic amino group. Examples of the substituted amino group include a monoalkylamino group, a dialkylamino group, a monoarylamino group, a diarylamino group, and an alkylarylamino group. Examples of the cyclic amino group include a pyrrolidine group, a piperidine group, a piperazine group, a morpholine group, a pyrrole group, a pyrazole group, an imidazole group, a pyridine group, a pyridazine group, a pyrimidine group, a pyrazine group, an oxazole group, an isoxazole group, a thiazole group, an isothiazole group, a pyrrolidone group, a piperidone group, a 3-morpholinone group, and a morpholinedione group.

The cationic polymer may be a block polymer or a random polymer. Examples thereof include: a polymer having a repeating unit derived from allylamine such as polyallylamine; a condensation polymer of epichlorohydrin and at least one kind selected from ammonia and an amine compound; Hoffman-modified polyacrylamide obtained by subjecting polyacrylamide to Huffman modification; and cation-modified polyvinyl alcohol. Of those, a polymer having a repeating unit derived from allylamine, and a condensation polymer of epichlorohydrin and at least one kind selected from ammonia and an amine compound are preferred.

The weight-average molecular weight of the cationic polymer is preferably from 500 to 2,500,000, more preferably from 600 to 2,000,000, still more preferably from 700 to 1,500,000.

As used herein, the weight-average molecular weight of the cationic polymer means the weight-average molecular weight in terms of polyethylene glycol measured by gel permeation chromatography (GPC).

As a commercially available product of the cationic polymer, there are given, for example: PAA series (polyallylamine) commercially available from Nittobo Medical Co., Ltd.; Unisense series (e.g., Unisense FCA1000L, Unisense FCA1001L, and Unisense FCA5000L (each of which is an aqueous solution of a copolymerized product of acrylamide and diallyldimethylammonium chloride), Unisense FPA100L, Unisense FPA101L, Unisense FPA102L, Unisense FPA1000L, Unisense FPA1001L, and Unisense FPA1002L (each of which is an aqueous solution of poly(diallyldimethylammonium chloride)), Unisense KHF10P (a dicyandiamide-formalin condensate), Unisense KHP10L and Unisense KHP10P (each of which is a dicyandiamide-diethylene triamine condensate), Unisense KHE100L, Unisense KHE101L, Unisense KHE102L, Unisense KHE105L, Unisense KHE1000L, and Unisense KHE1001L (each of which is an aqueous solution of a condensate of dimethylamine, ammonia, and epichlorohydrin), Unisense KHE104L (an aqueous solution of a condensate of dimethylamine and epichlorohydrin), Unisense FPV1000L (an aqueous solution of a poly(trimethylaminoethyl methacrylate-methyl sulfuric acid salt)), and Unisense ZCA100L (an aqueous solution of an acrylic acid salt-acrylamide-diallylamine hydrochloric acid salt copolymerized product)) commercially available from Senka Corporation; DIACATCH series commercially available from Mitsubishi Chemical Corporation; and EPOCROS WS-300 (an oxazoline group-containing polymer) commercially available from Nippon Shokubai Co., Ltd.

The addition amount of the cationic polymer is preferably from 0.01 part by mass to 10 parts by mass, more preferably from 0.05 part by mass to 8 parts by mass, still more preferably from 0.1 part by mass to 5 parts by mass with respect to 100 parts by mass of a solid content in the mixed liquid containing the carbon nanotube dispersion liquid and the carrier polymer material-containing solution. When the addition amount of the cationic polymer falls within the above-mentioned ranges, a solidified product can be efficiently obtained.

After the above-mentioned solidifying step, a generated lumpy solidified product is separated, washed with water, dehydrated, and dried at from about 80°C to about 110°C. Thus, a masterbatch can be obtained. As a drying method, for example, various drying devices, such as a single-screw extruder, an oven, a vacuum dryer, and an air dryer, can be used. The drying may be performed under normal pressure, but is preferably performed under reduced pressure (about 10 Pa to about 1,000 Pa). A drying time varies depending on the size of a dryer to be used and the like, but it is generally appropriate that the drying time be set to from about 30 minutes to about 180 minutes under reduced pressure. In addition, it is generally appropriate that the drying temperature be set to from about 50°C to about 150°C.

(Base Material)

The electromagnetic wave absorber of the present invention preferably includes at least one kind of base material selected from a resin, an elastomer, and a rubber. The resin may be a thermoplastic resin, or may be a thermosetting resin. An example of the resin is a known material, and examples thereof include a polyester resin, a polyether resin, a polyolefin resin (e.g., a polyethylene resin or a polypropylene resin), a polystyrene resin, a polyamide resin, a polycarbonate resin, an acrylic resin, a polyvinyl chloride resin, a polyphenylene sulfide resin, a polyphenylene ether resin, a polytetrafluoroethylene resin, a polyimide resin, a polyamide imide resin, a polyether imide resin, a polysulfone resin, a polyether sulfone resin, a polyketone resin, a polyether ketone resin, a polyether ether ketone resin, a polyarylate resin, a polyether nitrile resin, a phenol resin, a phenoxy resin, a fluororesin, a urea resin, a melamine resin, a benzoguanamine resin, an alkyd resin, an epoxy resin, a silicone resin, a urethane resin, a furan resin, and a xylene resin. An example of the elastomer is a known material, and examples thereof include a polystyrene elastomer, a polyolefin elastomer, a polyurethane elastomer, a polyester elastomer, a polyamide elastomer, a polybutadiene elastomer, a polyisoprene elastomer, a fluorine-based elastomer, and a silicone elastomer. An example of the rubber is a known material, and examples thereof include a natural rubber (NR), a styrene-butadiene rubber (SBR), an acrylonitrile-butadiene rubber (NBR), a nitrile rubber, a hydrogenated nitrile rubber, a polyisoprene rubber (IR), a butadiene rubber (BR), a butyl rubber (IIR), a chloroprene rubber (CR), an acrylic rubber (ACM), a fluorine rubber (FKM or PTFE), and a silicone rubber.

The base material is preferably a base material containing a rubber.

In addition, the base material is preferably at least one kind selected from a silicone resin, a silicone elastomer, and a silicone rubber, more preferably a silicone rubber for the reasons of heat resistance, chemical resistance, and durability.

When the carbon nanotubes are used in the form of a masterbatch, the base material may be a material of the same kind as that of the carrier polymer material of the masterbatch or may be a material of a different kind. When a silicone rubber is used as the base material, the carrier polymer material of the masterbatch is preferably at least one kind selected from a silicone resin, a silicone elastomer, and a silicone rubber, more preferably a silicon rubber for the reason that the constituent components of the base material and the carrier polymer material of the masterbatch are preferably close to each other.

The content of the base material in the electromagnetic wave absorber is preferably 60 mass% or more, more preferably 80 mass% or more, still more preferably 90 mass% or more, particularly preferably 95 mass% or more. The upper limit is preferably 99.9 mass% or less, more preferably 99.8 mass% or less, still more preferably 99.6 mass% or less. In addition, when the carbon nanotubes are used in the form of a masterbatch, the total content of the base material and the carrier polymer material contained in the masterbatch in the electromagnetic wave absorber is preferably 60 mass% or more, more preferably 80 mass% or more, still more preferably 90 mass% or more, particularly preferably 95 mass% or more. The upper limit is preferably 99.9 mass% or less, more preferably 99.8 mass% or less, still more preferably 99.6 mass% or less.

(Other Additive)

The electromagnetic wave absorber of the present invention may further include an additive as required. Examples of the additive include an antioxidant, a heat stabilizer, a light stabilizer, a UV absorber, a cross-linking agent, a pigment, a coloring agent, a foaming agent, an antistatic agent, a flame retardant, a lubricant, a softener, a tackifier, a plasticizer, a releasing agent, a deodorant, and a perfume.

The content of the additive in the electromagnetic wave absorber is preferably 30 mass% or less, more preferably 25 mass% or less, still more preferably 20 mass% or less, yet still more preferably 10 mass% or less, particularly preferably 5 mass% or less. The lower limit can also be set to 0 mass% or more, 0.01 mass% or more, or 0.1 mass% or more.

The electromagnetic wave absorber of the present invention can be used by being arranged on the surface of an electromagnetic wave reflection layer such as a metal layer.

The electromagnetic wave absorber of the present invention can be used as, for example, countermeasures against radiation noise of electronic devices, such as a communication device, a computer, a home electrical appliance, automobile electrical equipment, and medical electrical equipment, and electromagnetic wave reflection in an electronic toll collection system (ETC), a radar, and the like.

<Electromagnetic Wave Shielding Composite>

An electromagnetic wave shielding composite of the present invention is characterized by including:

the above-mentioned electromagnetic wave absorber of the present invention; and
an electromagnetic wave reflection layer formed on one surface side of the electromagnetic wave absorber.

In the electromagnetic wave shielding composite, the thickness of the electromagnetic wave absorber is preferably from 0.1 mm to 2.0 mm. The upper limit is preferably 1.8 mm or less, more preferably 1.5 mm or less. The lower limit is preferably 0.15 mm or more, more preferably 0.2 mm or more.

There is no particular limitation on the kind of the electromagnetic wave reflection layer in the electromagnetic wave shielding composite. For example, a metal layer including a metal such as aluminum foil may be used.

The thickness of the electromagnetic wave reflection layer is preferably from 0.005 mm to 1 mm. The lower limit is preferably 0.01 mm or more. The upper limit is preferably 0.9 mm or less, more preferably 0.8 mm or less.

In the electromagnetic wave shielding composite, the electromagnetic wave reflection layer may be formed on one surface side of the electromagnetic wave absorber via an adhesive layer, a tacky layer, or the like. In addition, the electromagnetic wave reflection layer may be formed on one surface side of the electromagnetic wave absorber by a method, such as sputtering or vapor deposition.

The minimum peak of the return loss of the electromagnetic wave absorber of the present invention is preferably -15 dB or less, more preferably -20 dB or less.

The electromagnetic wave shielding composite of the present invention can be used as, for example, countermeasures against radiation noise of electronic devices, such as a communication device, a computer, a home electrical appliance, automobile electrical equipment, and medical electrical equipment, and electromagnetic wave reflection in an electronic toll collection system (ETC), a radar, and the like.

Examples

The present invention is more specifically described below by way of Examples. The materials, usage amounts, ratios, treatment details, treatment procedures, and the like described in the following Examples can be appropriately changed without departing from the gist of the present invention. Thus, the scope of the present invention is not limited to the specific examples described below.

<Production of Carbon Nanotube>

A support film was formed on one surface of a silicon substrate by sputtering through use of aluminum as a target, and then a catalyst film was formed on the support film by sputtering through use of iron as a target.

Next, the substrate having the catalyst film formed thereon was placed upright in a reaction vessel of a CVD device. Next, the reaction vessel was closed, and a heater was simultaneously energized while the pressure was reduced to 1 Pa to start heating inside the reaction vessel. Then, when the temperature inside the reaction vessel approached 700°C, a nitrogen gas was supplied into the reaction vessel, and the exhaust from the inside of the reaction vessel was continuously performed with a pump so that the pressure inside the reaction vessel was able to be maintained at 90 kPa.

Next, the inside of the reaction vessel was heated to 750°C. Both a nitrogen gas and a hydrogen gas were supplied into the reaction vessel to maintain the pressure inside the reaction vessel at 30 kPa. After the temperature inside the reaction vessel reached 750°C, a nitrogen gas, a hydrogen gas, and an acetylene gas were supplied along the surface of the catalyst film from an upper end to a lower end of the substrate inside the reaction vessel while preheating with the above-mentioned heater was performed. While the pressure inside the reaction vessel was maintained at 30 kPa, synthesis of carbon nanotubes onto the substrate was performed to provide straight carbon nanotubes each having almost no waves, which had lengths of from 0.1 mm to 2 mm, an average length of 2.0 mm, 3 to 8 layers, 6 layers on average, diameters of from 5 nm to 12 nm, an average diameter of 9 nm, a specific surface area of 225 m$^2$/g, a G/D ratio of 0.8, and a metal impurity content of 250 ppm.

The length of each of the carbon nanotubes was evaluated from a SEM image photographed with a scanning electron microscope (manufactured by JEOL Ltd., model: JSM-7800F) under a state in which the carbon nanotube was on the substrate or after the carbon nanotube was cut from the substrate. In addition, the average length of the carbon nanotubes was determined by randomly selecting 30 carbon nanotubes from the SEM image and calculating an average value of the lengths of the 30 carbon nanotubes.

The number of layers and diameter of each of the carbon nanotubes were evaluated from a TEM image photographed with a transmission electron microscope (manufactured by Hitachi High-Tech Corporation, model: HF2200) under a state in which the carbon nanotube was on the substrate or after the carbon nanotube was cut from the substrate. The average number of layers of the carbon nanotubes was determined by: selecting any 30 fields of view from the TEM image from which the numbers of layers of the carbon nanotubes were able to be determined; and rounding off the number after the decimal point of the average value of the numbers of layers of the 30 carbon nanotubes. In addition, the average diameter of the carbon nanotubes was determined by: selecting any 30 fields of view from the TEM image; and rounding off the number after the decimal point of the average value of the diameters of the 30 carbon nanotubes.

The specific surface area (BET value) of the carbon nanotubes was measured by a gas adsorption method (multipoint method) using a specific surface area measuring device (manufactured by Shimadzu Corporation, model: 3Flex) in conformity with JIS Z8830 (ISO 9277).

The G/D ratio of the carbon nanotubes was determined with a Raman microscope (manufactured by Renishaw plc, model: inVia). Specifically, a value was determined by dividing the peak intensity of a G-band (1,590 cm$^{-1}$) of a Raman spectrum measured with the Raman microscope by the peak intensity of a D-band (1,350 cm$^{-1}$) thereof.

<Production of Carbon Nanotube Dispersion Liquid>

120 Grams of carboxymethyl cellulose (product name: Serogen WS-C, manufactured by DKS Co. Ltd.) was dissolved in 5,880 g of ion-exchanged water to prepare 6 kg of a CMC solution. 120 Grams of the carbon nanotubes obtained above and 23.8 kg of ion-exchanged water were added to the CMC solution, followed by stirring. Then, the resultant was treated with a cutter mixer (manufactured by FMI Corporation, ROBOT COUPE R-10E) at 3,000 rpm for 10 minutes to produce a carbon nanotube dispersion liquid 1.

<Production of Masterbatch>

(Production Example 1-1)

4.5 Kilograms of a silicone elastomer emulsion (product name: DOWSIL IE-7170, manufactured by Dow Toray Co., Ltd., solid content concentration: 48 mass%) was added to 30 kg of the carbon nanotube dispersion liquid 1 to prepare a mixed liquid. To this mixed liquid, 3,600 g of a 2 mass% solution of a cationic polymer (product name: DIACATCH CHP295, manufactured by Mitsubishi Chemical Corporation, weight-average molecular weight: 702,000) was added, followed by stirring. Further, a 20% formic acid solution was added until the above-mentioned mixed liquid was solidified. The resultant solidified product was filtered through a mesh having an opening of 149 μm, followed by the collection of the solidified product. The solidified product was dehydrated and then dried at 110°C to produce a masterbatch 1 (content of the carbon nanotubes: 5 mass%).

(Production Example 1-2)

12 Kilograms of a silicone elastomer emulsion (product name: ASAHI MRX-2269, manufactured by ASAHI DYESTUFF MFG.CO.,LTD, solid content concentration: 18 mass%) was added to 30 kg of the carbon nanotube dispersion liquid 1 to prepare a mixed liquid. To this mixed liquid, 3,600 g of a 2 mass% solution of a cationic polymer (product name: DIACATCH CHP295, manufactured by Mitsubishi Chemical Corporation, weight-average molecular weight: 702,000) was added, followed by stirring. Further, a 20% formic acid solution was added until the above-mentioned mixed liquid was solidified. The resultant solidified product was filtered through a mesh having an opening of 149 μm, followed by the collection of the solidified product. The solidified product was dehydrated and then dried at 110°C to produce a masterbatch 2 (content of the carbon nanotubes: 5 mass%).

<Production of Electromagnetic Wave Absorber>

(Examples 1 to 5)

Each of the masterbatches 1 and 2, and a base material were kneaded with Labo Plastomill (model: 4C150, Toyo Seiki Seisaku-Sho, Ltd.) in a blending composition shown in Table 1 below. As the base material, a material in which 2 parts by mass of a vulcanizing agent (product name: C8, Shin-Etsu Chemical Co., Ltd.) was blended with respect to 100 parts by mass of a silicone rubber (product name: KE-951-U, Shin-Etsu Chemical Co., Ltd.) was used.

The resultant kneaded product was further kneaded with a roll mill (two-roll mill, manufactured by Daihan Co., Ltd.), and then press-molded with a hydraulic heating and cooling press (model: 1811, Imoto machinery CO., LTD.). After that, the resultant was vulcanized to produce a sheet-shaped electromagnetic wave absorber having a thickness shown in the following table and measuring 15 cm long by 15 cm wide. In Table 1, the content of the carbon nanotubes in the electromagnetic wave absorber is shown in the "CNT concentration" column, and the specific gravity of the electromagnetic wave absorber is shown in the "Specific gravity" column.

<Measurement of Complex Permittivity>

The resultant electromagnetic wave absorber was set in a free space measuring device (model: FS-110, EM labs, Inc.) so that the film thickness direction was the incident direction of an electromagnetic wave. Then, the transmission and reflection coefficients at 24 GHz were measured with a network analyzer (model: PNA N5290, Keysight Technologies). Thus, the real part and imaginary part of the complex permittivity at a frequency of 24 GHz were derived.

<Measurement of Return Loss>

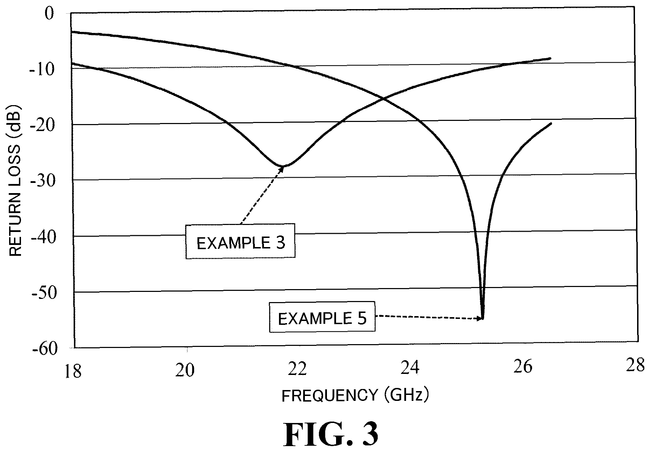

The electromagnetic wave absorber was set in a free space measuring device (model: FS-110, EM labs, Inc.) so that the film thickness direction was the incident direction of an electromagnetic wave in the same manner as in the measurement of the complex permittivity. The return loss of an electromagnetic wave at a frequency within a range of from 18 GHz to 45 GHz was measured with a network analyzer (model: PNA N5290, Keysight Technologies) in conformity with JIS R 1679. The return loss of each of the electromagnetic wave absorbers of Examples 1, 2, and 4 is shown in FIG. 2, and the return loss of each of the electromagnetic wave absorbers of Examples 3 and 5 is shown in FIG. 3.

<Evaluation of Fiber Bundle>

The resultant electromagnetic wave absorber was cut in the thickness direction. The cut surface of the electromagnetic wave absorber was observed with a scanning electron microscope, followed by the counting of the number of fiber bundles each having a maximum diameter of 100 nm or more (hereinafter sometimes referred to as "fiber bundles 1"), and the number of fiber bundles each having a maximum diameter of 5 nm or more and less than 100 nm (hereinafter sometimes referred to as "fiber bundles 2"), the fiber bundles being present per 10 $\mu$m$\times$10 $\mu$m. The number of the fiber bundles 1 is shown in the "Number of fiber bundles 1" column in the following table. In addition, the ratio (%) of the number of the fiber bundles 2 to the total of the number of the fiber bundles 1 and the number of the fiber bundles 2 (ratio of number of fiber bundles 2/total of number of fiber bundles 1 and number of fiber bundles 2) is shown in the "Ratio of fiber bundles 2" column in the following table. The number of counts shown in the table is an average value of the numbers counted for 10 squares each measuring 10 $\mu$m by 10 $\mu$m.

<Measurement of Total Light Transmittance>

The total light transmittance of the electromagnetic wave absorber was measured with a total light transmittance/transmission haze/transparency measuring device (haze-gard i, manufactured by BYK Gardner) in conformity with JIS K 7236 (ISO 14782).

<Measurement of Elongation at Break>

The elongation at break of the electromagnetic wave absorber was measured in conformity with JIS K 6251:2017.

Table 1

| | | Example 1 | Example 2 | Example 3 | Example 4 | Example 5 |
|---|---|---|---|---|---|---|
| Blending composition (mass%) | Masterbatch 1 | 13.8 | 15.6 | | | |
| | Masterbatch 2 | | | 15.6 | 17.6 | 17.6 |
| | Base material | 86.2 | 84.4 | 84.4 | 82.4 | 82.4 |
| Characteristics of electromagnetic wave absorber | CNT concentration (mass%) | 0.69 | 0.78 | 0.78 | 0.88 | 0.88 |
| | Thickness (mm) | 0.9 | 0.586 | 0.956 | 0.56 | 0.912 |
| | Specific gravity | 1.15 | 1.15 | 1.15 | 1.16 | 1.16 |
| | Elongation at break (%) | 370 | 340 | 330 | 320 | 320 |
| | Total light transmittance (%) | 8 | 5 | 1 | 2 | 0 |
| | Number of fiber bundles 1 | 0.5 | 2 | 1 | 0.5 | 1 |
| | Ratio of fiber bundles 2 (%) | 95 | 92 | 87 | 91 | 92 |
| | Complex permittivity at 24 GHz — Real part | 9.2 | 10.5 | 10.2 | 11.2 | 11.4 |
| | Complex permittivity at 24 GHz — Imaginary part | 3.1 | 3.7 | 3.6 | 4.3 | 4.7 |

Through use of each of the electromagnetic wave absorbers of Examples 1 to 5 in a communication device or the like, the malfunctions and like caused by electromagnetic wave interference between circuits within the device can be effectively suppressed.

**Claims**

1.   An electromagnetic wave absorber, comprising fibrous carbon,

wherein the electromagnetic wave absorber has a complex permittivity with a real part of from 6 to 30 and an imaginary part of from 1 to 25 at a frequency of 24 GHz, and
wherein, when the electromagnetic wave absorber is cut, the number of fiber bundles of the fibrous carbon observed on a cut surface of the electromagnetic wave absorber, the fiber bundles each having a maximum diameter of 100 nm or more, is 10 or less per 10 $\mu$m$\times$10 $\mu$m.

2.   The electromagnetic wave absorber according to claim 1, wherein, when the electromagnetic wave absorber is cut, a ratio of the number of the fiber bundles each having a maximum diameter of 5 nm or more and less than 100 nm to a total of the number of the fiber bundles each having a maximum diameter of 5 nm or more and less than 100 nm, and the number of the fiber bundles each having a maximum diameter of 100 nm or more observed per 10 $\mu$m$\times$10 $\mu$m of the cut surface of the electromagnetic wave absorber is 80% or more.

3.   The electromagnetic wave absorber according to claim 1 or 2, wherein the electromagnetic wave absorber comprises the fibrous carbon in a content of from 0.2 mass% to 1.5 mass%.

4.   The electromagnetic wave absorber according to claim 1 or 2,

wherein the electromagnetic wave absorber comprises the fibrous carbon and a base material, and
wherein the base material contains at least one kind selected from a resin, an elastomer, and a rubber.

5.   The electromagnetic wave absorber according to claim 4, wherein the base material contains at least one kind selected from a silicone resin, a silicone elastomer, and a silicone rubber.

6.   The electromagnetic wave absorber according to claim 1 or 2, wherein the fibrous carbon is a carbon nanotube.

7.   The electromagnetic wave absorber according to claim 1 or 2,

wherein the electromagnetic wave absorber comprises the fibrous carbon and a base material,
wherein the fibrous carbon is a carbon nanotube,

wherein the base material contains at least one kind selected from a silicone resin, a silicone elastomer, and a silicone rubber, and

wherein the electromagnetic wave absorber comprises the fibrous carbon in a content of from 0.2 mass% to 1.5 mass%.

8. The electromagnetic wave absorber according to claim 1 or 2, wherein the electromagnetic wave absorber has an elongation at break measured in conformity with JIS K 6251:2017 of 150% or more.

9. The electromagnetic wave absorber according to claim 1 or 2, wherein the electromagnetic wave absorber has a thickness of from 0.2 mm to 2.0 mm.

10. The electromagnetic wave absorber according to claim 1 or 2, wherein the electromagnetic wave absorber has a specific gravity of 2.5 or less.

11. The electromagnetic wave absorber according to claim 1 or 2, wherein the electromagnetic wave absorber has a total light transmittance measured in conformity with ISO 13468 of 20% or less.

12. An electromagnetic wave shielding composite, comprising:

    the electromagnetic wave absorber of claim 1 or 2; and
    an electromagnetic wave reflection layer formed on one surface side of the electromagnetic wave absorber.

**FIG. 1**

**FIG. 2**

FIG. 3

**EP 4 531 513 A1**

## INTERNATIONAL SEARCH REPORT

| International application No. |
|---|
| **PCT/JP2022/021147** |

**A. CLASSIFICATION OF SUBJECT MATTER**

*H05K 9/00*(2006.01)i
FI: H05K9/00 X

According to International Patent Classification (IPC) or to both national classification and IPC

**B. FIELDS SEARCHED**

Minimum documentation searched (classification system followed by classification symbols)

H05K9/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2020/111159 A1 (KANSAI PAINT CO LTD) 04 June 2020 (2020-06-04) entire text, fig. 1-2 | 1-12 |

☐ Further documents are listed in the continuation of Box C.    ☑ See patent family annex.

| | |
|---|---|
| * Special categories of cited documents: <br> "A" document defining the general state of the art which is not considered to be of particular relevance <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| **04 August 2022** | **16 August 2022** |

| Name and mailing address of the ISA/JP | Authorized officer |
|---|---|
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (January 2015)

**INTERNATIONAL SEARCH REPORT**
Information on patent family members

International application No.

**PCT/JP2022/021147**

| Patent document cited in search report | | | Publication date (day/month/year) | Patent family member(s) | Publication date (day/month/year) |
|---|---|---|---|---|---|
| WO | 2020/111159 | A1 | 04 June 2020 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2021230140 A1
- JP 2020180251 A